(19) Europäisches Patentamt
European Patent Office
Office européen des brevets

(11) **EP 4 478 061 A1**

(12) **EUROPEAN PATENT APPLICATION**

(43) Date of publication:
**18.12.2024 Bulletin 2024/51**

(21) Application number: **23179291.2**

(22) Date of filing: **14.06.2023**

(51) International Patent Classification (IPC):
**G01R 27/18** (2006.01)    **G01R 31/52** (2020.01)

(52) Cooperative Patent Classification (CPC):
**G01R 27/18; G01R 31/52**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Hamilton Sundstrand Corporation Charlotte, NC 28217 (US)**

(72) Inventor: **FERNANDEZ-MATTOS, Rodrigo Solihull (GB)**

(74) Representative: **Dehns
10 Old Bailey
London EC4M 7NG (GB)**

(54) **INSULATION FAULT MONITORING**

(57)    A method for detecting an insulation fault in an unearthed electrical system, the system comprising a first rail and a second rail, each rail having an insulation resistance. The method comprises, in an initial stage: connecting the first rail to a relative ground through a first resistive component, wherein the first rail has an initial stage first rail voltage in the initial stage; and charging a capacitor to a capacitor voltage using the first rail, wherein the capacitor voltage is indicative of the initial stage first rail voltage. In a subsequent stage: connecting the second rail to the relative ground through a second resistive component; wherein the first rail has a subsequent stage first rail voltage; and determining if a fault has occurred by using the capacitor voltage and the subsequent stage first rail voltage.

Figure 1

EP 4 478 061 A1

**Description**

FIELD OF THE INVENTION

The invention relates to a method and circuit for detecting an insulation fault in an unearthed electrical system; an insulation monitoring device; and an aircraft electrical system.

BACKGROUND

There are established requirements and standards, for example as specified in EN 61557-8, for insulation monitoring devices for unearthed electrical systems. These include having the ability to detect symmetrical and asymmetrical components in a fault. Passive measuring techniques are known to be only capable of detecting asymmetrical insulation faults because equal voltage displacement during symmetrical faults results in no current flow. Active measuring techniques, for example where a known pulse is injected into the system and the returning current is measured are capable of detecting symmetrical faults. However, these techniques can be complex to implement.

SUMMARY

In a first aspect there is provided a method for detecting an insulation fault in an unearthed electrical system, the system comprising a first rail and a second rail, each rail having an insulation resistance. The method comprises, in an initial stage: connecting the first rail to a relative ground through a first resistive component, wherein the first rail has an initial stage first rail voltage in the initial stage; and charging a capacitor to a capacitor voltage using the first rail, wherein the capacitor voltage is indicative of the initial stage first rail voltage. In a subsequent stage: connecting the second rail to the relative ground through a second resistive component; wherein the first rail has a subsequent stage first rail voltage; and determining if a fault has occurred by using the capacitor voltage and the subsequent stage first rail voltage.

The insulation resistance on the first and second rail in an unearthed electrical system can be measured by connecting resistive components into the system between the rail and a relative ground. However, because the insulation resistance of either rail is measured with respect of the same relative ground, the rail voltage with respect of the relative ground for a given insulation resistance of the first rail will be affected by the insulation resistance of the second rail. As a result, in order to determine the insulation resistance of either rail, and thus whether a fault has occurred, complex equations with several unknowns must be resolved based on measured voltages.

By charging a capacitor in an initial stage, the voltage level of the capacitor can be held for use in a subsequent stage, which can be at a different point in time. By using the stored capacitor voltage from the initial stage and the subsequent stage first rail voltage, voltage measurements from two different stages can be used to determine whether a fault has occurred. The Applicant has discovered that, by using voltage measurements from different stages, an insulation fault may be more readily detected. The method is therefore advantageously able to determine if a fault has occurred in the insulation of the first or second rail, whilst being capable of implementation in an analogue system.

An analogue system can offer benefits in cases where digital means are not available. An analogue system can also be a relatively cost effective and simple solution as it does not require programmable microcontrollers which may be costly.

The method is thus capable of detecting symmetrical and asymmetrical insulation levels, and conforming to established standards. No signals are required for injection onto the rails, and the insulation resistance in each rail can be determined independent of (without interference on) the other rail.

In some examples the second rail has a subsequent stage second rail voltage in the subsequent stage, and a difference between the subsequent stage first rail voltage and the subsequent stage second rail voltage is defined as a differential voltage; and the differential voltage is used in determining if a fault has occurred.

In some examples the differential voltage is scaled by a threshold scaling factor to determine a threshold voltage; and the threshold voltage is used in determining if a fault has occurred.

The threshold scaling factor may be determined by dividing a minimum acceptable insulation resistance by the sum of the minimum acceptable insulation resistance plus the resistance of the resistive component.

In some examples the capacitor voltage is scaled by a capacitor scaling factor to define a scaled capacitor voltage; and the scaled capacitor voltage is used in determining if a fault has occurred.

In some examples, the method further comprises measuring a voltage difference between the capacitor voltage or the scaled capacitor voltage and the subsequent stage first rail voltage to define a measured voltage; and using the measured voltage in determining if a fault has occurred.

The capacitor scaling factor may be determined by dividing the resistance of the resistive component by the sum of a minimum acceptable insulation resistance plus the resistance of the resistive component.

In some examples the measured voltage is compared against the threshold voltage to determine if a fault has occurred.

In some examples, if the measured voltage is less than the threshold voltage then a fault has occurred.

In some examples, if the measured voltage is not less than the threshold voltage then a fault has not occurred.

In a second aspect there is provided a circuit for detecting an insulation fault in an unearthed electrical system, the system comprising a first rail and a second rail, each rail having an insulation resistance. The circuit comprises a timing component configured to output a timing signal which configures the circuit into an initial configuration or a subsequent configuration. The initial configuration comprises a first resistive component connected between the first rail and a relative ground, wherein the first rail has an initial first rail voltage in the initial configuration; and a capacitor connected to the first rail, wherein the capacitor has a capacitor voltage resulting from charging by the first rail in the initial configuration. The subsequent configuration comprises a second resistive component connected between the second rail and a relative ground; wherein the first rail has a subsequent first rail voltage in the subsequent configuration and the second rail has a subsequent second rail voltage; the circuit further comprising circuitry configured to use the capacitor voltage and the subsequent first rail voltage to determine if a fault has occurred.

In some examples the circuit further comprises a first operational amplifier configured to output a difference between the subsequent first rail voltage and the subsequent second rail voltage as a differential voltage. The differential voltage is used in determining if a fault has occurred.

In some examples the circuit further comprises a first operational amplifier configured to output a difference between the initial first rail voltage and the initial second rail voltage as a differential voltage. The differential voltage is used in determining if a fault has occurred.

In some examples the circuit further comprises a first operational amplifier configured to output a difference between the first rail voltage and the second rail voltage as a differential voltage. The differential voltage is used in determining if a fault has occurred.

In some examples the differential voltage is scaled by a threshold scaling component to determine a threshold voltage. The threshold voltage is used in determining if a fault has occurred.

In some examples the circuit further comprises a scaling component configured to scale the capacitor voltage by a capacitor scaling factor to determine a scaled capacitor voltage. The scaled capacitor voltage is used in determining if a fault has occurred.

In some examples the circuit further comprises a second operational amplifier configured to output a voltage difference between the capacitor voltage or the scaled capacitor voltage and the subsequent first rail voltage, the second operational amplifier output being defined as a measured voltage. The measured voltage is used in determining if a fault has occurred.

In some examples the circuit further comprises a comparator configured to compare the measured voltage against the threshold voltage to determine if a fault has occurred.

In some examples, if the measured voltage is less than the threshold voltage then the comparator outputs a first signal which corresponds to a fault having occurred.

In some examples, if the measured voltage is not less than the threshold voltage then the comparator outputs a second signal which corresponds to a fault not having occurred.

In a third aspect there is provided an insulation monitoring device for an aircraft electrical system comprising the circuit of the second aspect.

In a fourth aspect there is provided an aircraft electrical system comprising the circuit of the second aspect or the insulation monitoring device of the third aspect; and a first rail and a second rail, each rail having an insulation resistance.

In some examples the first or second rail is for providing electrical power to a propulsive load.

The circuit of the second aspect, the insulation monitoring device of the third aspect, or the aircraft electrical system of the fourth aspect may comprise any of the features of the examples described with respect to the first aspect, including features derived from functional steps.

BRIEF DESCRIPTION OF THE DRAWINGS

Various examples will now be described with reference to the accompanying drawings in which:

Figure 1 schematically shows connections between an unearthed aircraft electrical system and parts of a fault monitoring device.
Figure 2 shows process logic blocks of a fault monitoring device.
Figure 3 shows parts of a capacitive component.
Figure 4 shows method steps for detecting an insulation fault in an unearthed electrical system.

DETAILED DESCRIPTION

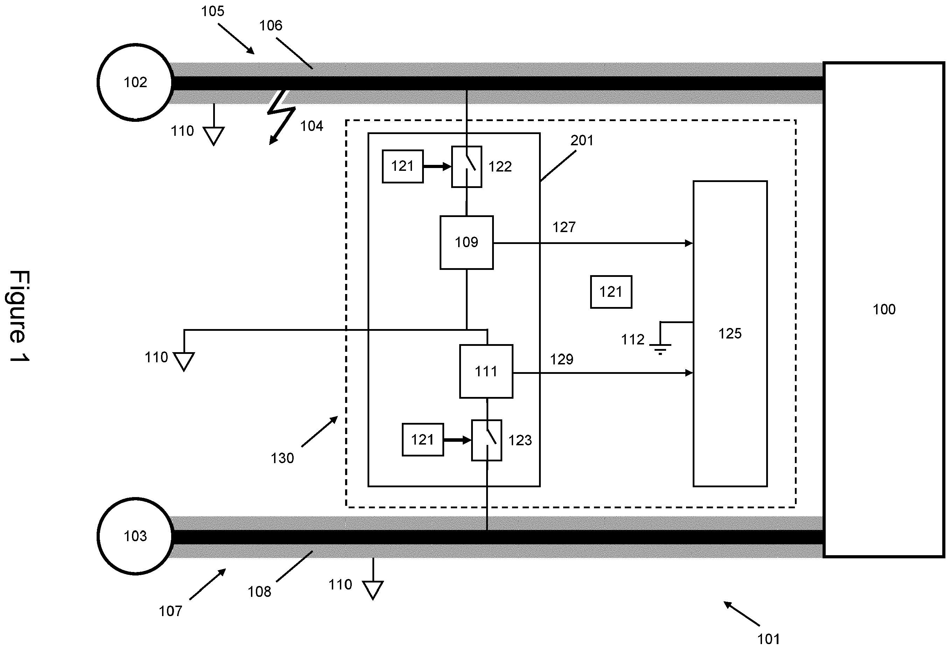

With reference to Figure 1, an unearthed aircraft electrical system 101 includes a first power terminal 102, a second power terminal 103, a first rail 105, a second rail 107 and a load 100.

The first rail 105 is connected to the first power terminal 102. The second rail 107 is connected to the second power terminal 103. There is a potential difference (i.e. a voltage) between the first power terminal 102 and the second power terminal 103, which is induced onto the first and second rails 105, 107. The voltage may be up to 1500V direct current (DC).

The first and second rails 105, 107 are connected to the load 100, and are thus able to transfer electrical power from the power terminals 102, 103 to the load 100. The system 101 is thus configured to allow a current to flow from the power terminals 102, 103 through the rails 105,107 and into the load 100 wherein energy may be dissipated or consumed.

As a result of the power flow from the first and second rails 105, 107 to the load 100, insulation is required on the first and second rails 105, 107. The insulation is for the purpose of protecting electrical aspects of the first and second rails 105, 107, for example the power flow. The insulation may also provide mechanical benefits, for example improved load bearing etc.

The first rail 105 has insulation 106, and the second rail 107 has insulation 108. The insulation 106, 108 on each rail 105, 107 is shown in Figure 1 from an electrical perspective as providing insulation resistance relative to a ground 110.

It is important to note that, throughout this disclosure, the ground 110 is a relative ground. This means that there is no physical connection to Earth, for example because the system is in an aircraft, and the ground 110 is in essence "floating" relative to other voltage levels, for example the power terminals 102, 103, in the system 101.

The voltage on the rails 105, 107 may be relatively high (up to 1500V DC). In aircraft applications, the rails 105, 107 may be located, for example, nearby a flammable fuel system or other critical system. In the event that an insulation fault causes the voltage on the first or second rails 105, 107 to cause a current to flow in another aircraft system, the consequences of such a fault could be disastrous for the aircraft. As such, there is a particular concern in aircraft applications to be able to accurately monitor and detect faults in the insulation.

A fault is generally to be understood as a break in the insulation, such that a conductive part of the rail 105, 107 becomes or is able to contact a part outside of the system 101 in an unintended manner.

In order to standardise monitoring of electrical insulation failures, there are known standards, such as EN 61557-8. These standards define the requirements for insulation monitoring devices in unearthed electrical systems, such as system 101. These standards include that insulation monitoring devices shall be capable of monitoring the insulation resistance of unearthed systems, including symmetrical and asymmetrical components, and give a warning if the insulation resistance between the system and earth falls below a predetermined level. In order to meet this standard, complex mathematical equations may need to be resolved by a fault monitoring device.

Additionally, there are some applications which require or take benefit from analogue circuitry. Analogue circuitry can include, for example, a circuit which does not require a dedicated microcontroller or programmable logic device. Analogue circuitry of this type can be cost effective and reliable.

With continued reference to Figure 1, a fault monitoring device 130 comprises signal conditioning circuitry 201, a timing component 121, and further circuitry 125. The fault monitoring device 130 is connected to the system 101 at the first rail 105, at second rail 107, and at the ground 110.

The signal conditioning circuitry 201 includes a first switch 122, a first resistive component 109, a second switch 123 and a second resistive component 111.

The first resistive component 109 is electrically connectable between the first rail 105 and the ground 110 by the first switch 122. The second resistive component 111 is electrically connectable between the second rail 107 and the ground 110 by the second switch 123. The first and second resistive components 109, 111 may comprise a single or a plurality of resistors. The resistors may be configured to form a potential divider. The switches 122, 123 are controlled by the timing component 121, as discussed further below.

The further circuitry 125 is connected by a line 127 to the first resistive component 109. The further circuitry 125 is also connected by a line 129 the second resistive component 111. The further circuitry 125 is connected to a signal ground 112.

The signal ground 112 is similar to the ground 110 in that the signal ground 112 provides a relatively neutral voltage for return signals. However, the signal ground 112 is isolated, for electrical safety, from the ground 110, as discussed below.

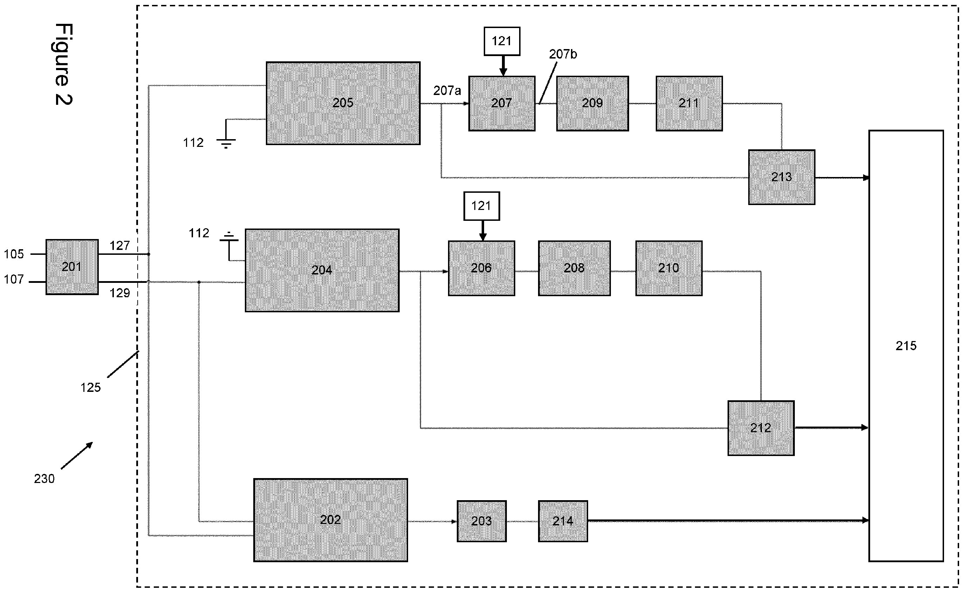

Referring to Figure 2, the fault monitoring device 130 comprises a plurality of logic processing components 230. These components can be implemented using analogue circuitry, and do not require dedicated programmable logic devices or microcontrollers. However, if it is desired, some of the process logic shown in Figure 2 can also be implemented digitally, for example programmed into a programmable logic device.

The logic processing components 230 includes the signal conditioning stage 201. The remaining blocks of the logic processing components 230 provide isolation and signal processing that may be implemented in the further circuitry 125 shown in Figures 1 and 2.

The signal conditioning stage 201 is connected to the first rail 105 and the second rail 107. The signal conditioning stage 201 outputs first and second conditioned signals 127, 129 corresponding to the voltage of the first and second rails 105, 107 respectively. The first and second conditioned signals 127, 129 are analogue signals.

The first and second conditioned signals 127, 129 are provided to a first operational amplifier 202. The output of the first operational amplifier 202 is connected to a threshold scaling component 203, which is connected to a buffer 214.

The first conditioned signal 127 is provided to a first isolation device 205 and the second conditioned signal 129 is provided to a second isolation device 204. Each of the isolation devices 204, 205, and optionally the first operational amplifier 202, are connected to the sensing ground 112 which enables the output of the isolation devices 204, 205 to be electrically isolated. This provides additional electrical safety.

The isolation devices 204, 205 may be, for example, differential isolating amplifiers configured to measure a voltage difference between their inputs and output a differential voltage that can be referenced to a different ground, for example the sensing ground 112, because the inputs and the output are galvanically isolated.

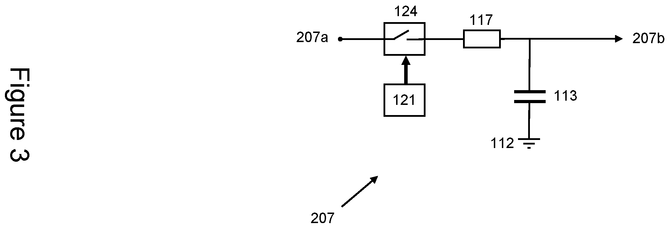

The first isolation device 205 outputs an upper isolation signal, corresponding to the first rail 105, to an upper capacitive component 207 and to an upper second operational amplifier 213. The upper capacitive component 207 includes a switch which is controlled by the timing component 121. A more detailed schematic of a capacitive component is discussed in relation to Figure 3 below.

The upper capacitive component 207 is connected to an upper buffer 209, which is connected to an upper scaling component 211. The upper scaling component 211 is connected to the upper second operational amplifier 213. Thus, the upper second operational amplifier 213 receives two inputs: the upper isolation signal from the first isolation device 205 and the output of the upper scaling component 211.

The second isolation device 204 outputs a lower isolation signal, corresponding to the second rail 107, to a lower capacitive component 206 and to a lower second operational amplifier 212. The lower capacitive component 206 includes a switch which is controlled by the timing component 121. A more detailed schematic of a capacitive component is discussed in relation to Figure 3 below.

The lower capacitive component 206 is connected to a lower buffer 208, which is connected to a lower scaling component 210. The lower scaling component 210 is connected to the lower second operational amplifier 212. Thus, the lower second operational amplifier 212 receives two inputs: the lower isolation signal from the second isolation device 204 and the output of the lower scaling component 210.

The upper components 205, 207, 209, 211 and 213 operate in substantially the same manner as the lower components 204, 206, 208, 210 and 212. However, the upper components are configured to process signals corresponding to the first rail 105, whereas the lower components are configured to process signals corresponding to the second rail 107.

It is to be understood that, although this specification describes features in relation to the first rail 105, the terminology of "first" and "second" and "upper" and "lower" is not limiting. Specifically, the methods and circuits disclosed in relation to detecting a fault on the first rail 105 can and are equally applicable to the second rail 107.

Referring to Figure 3, a detailed schematic of the capacitive component 207 is disclosed. The capacitive component 207 comprises a capacitor 113, a resistor 117 and a switch 124. The capacitive component 207 has an input 207a and an output 207b. The switch 124 is controlled by the timing component 121.

The switch 124 is connected in series with the resistor 117 and the capacitor 113. The output 207b of the capacitive component is connected between the resistor 117 and the capacitor 113. The capacitor 113 is connected to the signal ground 112.

In a normal operating condition, the first power terminal 102 is at a constant 750V, and the second power terminal is at constant -750V. The potential difference between the first and second power terminals 102, 103 is therefore 1500V DC. The relative ground 110 is at a voltage approximately half way between the first and second power terminals 102, 103. The ground 110 is therefore at 0V.

The voltage from the first and second power terminals 102, 103 is induced onto the first and second rails 105, 107 respectively, and power is transferred to the load 100.

In order to monitor and determine whether a fault 104 has occurred on, for example, the first rail 105, information is needed from both of the first and second rails 105, 107. The information must additionally be collected at a point wherein the first rail 105 is connected to ground through the first resistive component 109, and at a point when the first rail 105 is not connected to ground through the first resistive component 109. This is due to the relative ground 110 linking the first and second rails 105, 107 together via the insulation 106, 107. Although the insulation 106, 107 is large, in practice it is not infinite and therefore a small leakage current will pass through the insulation 106, 107.

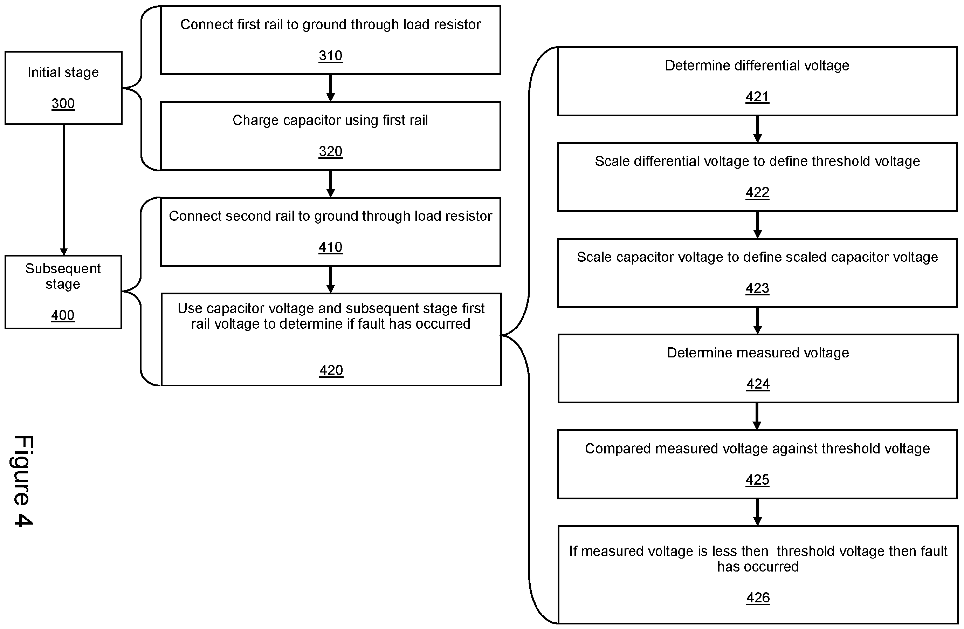

With reference to Figure 4, in order to gather information for each of the rails 105, 107, the device 130 alternates between an initial stage 300 and a subsequent stage 400.

The timing component 121 outputs a timing signal. For example, the timing signal is a square waveform which alternates between a high voltage and a zero or a low voltage. The period of the waveform is, for example, 10ms. The period of the waveform can be determined by the capacitance of the rails 105, 107 with respect to the ground 110.

The device 130 is configured to use the timing signal to trigger a stage change. Thus, as the timing signal alternates between the two stages, the device 130 and the corresponding method alternates or sequentially moves from the initial stage 300 to the subsequent stage 400.

As discussed above the Applicant has devised an improved way of monitoring and detecting faults on an insulated line. The relationship between the first rail 105 voltage during the subsequent stage 400 and other voltages may be expressed by equation 1 below.

$$V_+ - (G \times V_{c+}) = F \times V_d$$

Equation 1

Wherein $V_+$ is the first rail 105 voltage during the subsequent stage 400, G is a capacitor voltage scaling factor, $V_{c+}$ is a capacitor voltage from the initial stage 300, F is a threshold scaling factor, and $V_d$ is a differential voltage. Each of these terms are explained below.

Equations 2 and 3 below describe how each of the scaling factors G and F are determined.

$$G = \frac{R_I}{R_I + R_{F+}}$$

Equation 2

$$F = \frac{R_{F+}}{R_{F+} + R_I}$$

Equation 3

Wherein $R_I$ is the resistance of the first resistive component 109 and $R_{F+}$ is the minimum acceptable insulation resistance of the insulation 106 of the first rail 105.

Thus, in order to determine if a fault 104 has occurred in the insulation 106, the parameters G and F must first be decided. In this example, $R_I$ is set to 500k Ohms, and $R_{F+}$ is set to 300k Ohms. It is thus defined that an insulation resistance of less than 300k Ohms will be determined to be a fault. As a result, the parameters G and F can be calculated as: G = 0.625 and F = 0.375. Because G and F are scaling factors, they are unitless. For this example, equation (1) becomes:

$$V_+ - (0.625 \times V_{c+}) = 0.375 \times V_d$$

The unknown parameters in the equation thus become $V_+$, $V_{c+}$ and $V_d$. In order to determine these parameters, the method as disclosed in Figure 4 is implemented in the device 130, by the logic processing components 230.

In the initial stage 300, in a first step 310 the first rail 105 is connected to ground 110 through the resistive component 109. The step 310 is implemented by the first switch 122 receiving the timing signal from the timing component 121 (for example, a high voltage signal). During this step, the second rail 107 is not connected to ground through the second resistive component 111.

During the same period of the timing signal, a second step 320 comprises charging capacitive component 207, which may for example be the capacitor 113, from the voltage of the first rail 105. This is implemented by capacitive component 207 receiving the same timing signal from the timing component 121, which may cause for example the switch 124 to connect the capacitor 113 to the first rail 105 via the first isolation device 205. The capacitor subsequently charges as the voltage on the capacitor rises to that of the first rail 105 voltage, or to a capacitor voltage which is indicative of the initial stage 300 first rail 105 voltage.

The resistor 117 is used to control the rate of charge of the capacitor 113. The resistor 117 is configured such that the capacitor 113 charges in a sufficient time relative to the period of the timing signal.

At the end of the period (for example, after 10ms), the timing component 121 changes the timing signal output to, for example, a low voltage signal, which corresponds to the device 130 entering the subsequent stage 400.

In the subsequent stage 400, a first step 410 comprises connecting the second rail 107 to ground 110 through the resistive component 111. The step 410 is implemented by the second switch 123 receiving the timing signal from the timing component 121 (for example, the low voltage signal). During this step, the first rail 105 is not connected to ground through the first resistive component 109. This is because the first switch 122 is in an open configuration when receiving a low voltage signal from the timing component 121.

During the same period of the timing signal, the capacitive component 206 may be charged. This is implemented by a switch in the capacitive component 206 receiving the same timing signal from the timing component 121, which causes the capacitive component 206 to connect to the second rail 107 via the second isolation device 204. The capacitive component 206 charges and the voltage on the capacitive component 206 rises.

During the same period of the timing signal, a second step 420 uses the voltage of the capacitor 113, and the subsequent stage 400 first rail 105 voltage in order to determine if a fault 104 has occurred.

In step 421, the device 130 determines a difference between the subsequent stage 400 first rail 105 voltage and the subsequent stage 400 second rail 107 voltage as the differential voltage $V_d$. This is implemented by the first operational amplifier 202. The first operational amplifier 202 outputs the differential voltage $V_d$.

In an alternative arrangement, in step 421 the device 130 determines a difference between the initial stage 400 first rail 105 voltage and the initial stage 400 second rail 107 voltage as the differential voltage $V_d$.

In an alternative arrangement, in step 421 the device 130 determines a difference between the first rail 105 voltage and the second rail 107 voltage as the differential voltage $V_d$. The first rail 105 voltage and the second rail 107 voltage may thus be stage independent.

In step 422 the differential voltage $V_d$ is scaled by scaling factor F, which as described above has been set to 0.375. The scaling is implemented by the threshold scaling component 203 scaling the differential voltage $V_d$ by 0.375, and outputting the scaled differential voltage to the buffer 214. The scaled differential voltage can be defined as a threshold voltage ($V_{th}$). The threshold voltage $V_{th}$ will be used to determine if a fault has occurred, as described further below. Equation 1 thus becomes:

$$V_+ - (0.625 \times V_{c+}) = V_{th}$$

Wherein $V_{th}$ is known as discussed above, and the unknown parameters are $V_+$ and $V_{c+}$.

In step 423, the capacitor voltage from the initial stage 300 is scaled. This is implemented by a combination of the capacitive component 207, the buffer 209 and the scaling component 211.

As discussed previously, the capacitive component 207 includes a switch 124 which is controlled by the timing signal. In the initial stage 300, the switch 124 connected the capacitor 113 to the first rail 105, which charged the capacitor 113. In the subsequent stage 400, the timing signal causes the switch 124 to disconnect the capacitor 113 from the first rail 105. As a result, throughout the subsequent stage 400, the capacitor 113 has a voltage based on the first rail 105 in the initial stage 300.

As such, in the subsequent stage 400, when the device 130 scales the voltage of the capacitor 113 to determine the scaled capacitor voltage, the scaled capacitor voltage is a scaled version of the voltage of the first rail 105 in the initial stage 300.

Thus, step 423 is implemented by the capacitive component 207 outputting the capacitor voltage to the buffer 209, and then to the scaling component 211. The scaling component 211 scales the capacitor voltage by the scaling factor G (0.625), and outputs the scaled capacitor voltage.

In step 424, the difference between the scaled capacitor voltage and the subsequent stage 400 first rail 105 voltage is processed and defined as a measured voltage ($V_m$). This is implemented by the second operational amplifier 213 receiving the subsequent stage 400 first rail 105 voltage directly from the isolation device 205 (i.e. the upper isolation signal) and the scaled capacitor voltage from the scaling component 211. The second operational amplifier 213 outputs the measured voltage $V_m$.

It is important to note that, in step 424, the output of the second operational amplifier 213, $V_m$, is determined based on the first rail 105 voltage in the subsequent stage 400 (directly from the isolation device 205) and the first rail 105 voltage in the initial stage 300 (as a result of the timing signal provided to the capacitive component 207). In this manner, the objective (as discussed above) of providing information at a point wherein the first rail 105 is connected to ground through the first resistive component 109, and at a point when the first rail 105 is not connected to ground through the first resistive component 109, is met.

In step 425, the measured voltage $V_m$ is compared to the threshold voltage $V_{th}$ to determine if a fault has occurred. This is implemented by a comparator 215 receiving the threshold voltage $V_{th}$ from the buffer 214, and receiving the measured voltage $V_m$ from the second operational amplifier 213. The comparator 215 compares the signals $V_m$ and $V_{th}$.

In step 426, it is determined if a fault has occurred by assessing if $V_m < V_{th}$. If this condition is met then a fault has occurred. If this condition is not met, then a fault has not occurred.

In a first example it is determined that $V_m$ is not less than $V_{th}$, and therefore a fault has not occurred. In this case the device 130 continues to monitor the system 101 using the method discussed above.

In another example, it is determined that $V_m$ is less than $V_{th}$. The device 130 thus determines that a fault 104 has occurred in the insulation 106 of the first rail 105. The device 130 is able to then output the signal from the comparator 215 to any other part of the aircraft electrical system 101 in order for appropriate action, for example engaging a circuit breaker. Thus, appropriate safety measures can be taken in order to protect the system 101 or the aircraft from damage as a result of the identified fault 104.

Although the present example is disclosed in relation to the first rail 105, it is to be understood that adjustments can easily be made to adapt the disclosed method and circuit for the second rail 107.

In particular, the step 310 would comprise connecting the second rail 107 to ground through the resistive component 111. Step 320 would comprise charging the capacitive component 206 using the second rail 107. Step 410 would comprise connecting the first rail 105 to ground through the resistive component 109. The components used in relation to steps 421 to 426 would be the lower components (204, 206, 208, 210 and 212) which correspond to the second rail 107.

It is also to be understood that some components may have dual functionality. For example, the resistive component 109 may be configured to be switched in a manner that allows the resistive component 109 to connect to the first rail 105 in the initial stage 300, and to the second rail 107 in the subsequent stage 400. This can be achieved, for example, through a configuration of transistor switches. Additionally, the capacitor 113, the switches, and the upper or lower components may all offer dual functionality.

It is also to be understood that aspects of the logic processing components 230 process signals simultaneously. Specifically, the first operational amplifier 202, and the isolation devices 204, 205 are in parallel and thus process signals simultaneously, as do the subsequent components following each of these devices (i.e. 207, 209, 211, 213 are in parallel to 206, 208, 210, 212 and 203, 214, etc.).

Various aspects of the apparatus and methods disclosed in the various embodiments may be used alone, in combination, or in a variety of arrangements not specifically discussed in the embodiments described in the foregoing, and this disclosure is therefore not limited in its application to the details and arrangement of components set forth in the foregoing description or illustrated in the drawings. For example, aspects described in one embodiment may be combined in any manner with aspects described in other embodiments. Although particular embodiments have been shown and described, it will be obvious to those skilled in the art that changes and modifications may be made without departing from this invention in its broader aspects. The scope of the following claims should not be limited by the embodiments set forth in the examples, but should be given the broadest reasonable interpretation consistent with the description as a whole.

## Claims

1. A method for detecting an insulation fault in an unearthed electrical system, the system comprising a first rail and a second rail, each rail having an insulation resistance; the method comprising:

in an initial stage:

connecting the first rail to a relative ground through a first resistive component, wherein the first rail has an initial stage first rail voltage in the initial stage; and charging a capacitor to a capacitor voltage using the first rail, wherein the capacitor voltage is indicative of the initial stage first rail voltage; and

in a subsequent stage:

connecting the second rail to the relative ground through a second resistive component; wherein the first rail has a subsequent stage first rail voltage; and determining if a fault has occurred by using the capacitor voltage and the subsequent stage first rail voltage.

2. The method of claim 1, wherein the second rail has a subsequent stage second rail voltage in the subsequent stage, and a difference between the subsequent stage first rail voltage and the subsequent stage second rail voltage is defined as a differential voltage; and the differential voltage is used in determining if a fault has occurred.

3. The method of claim 2, wherein

the differential voltage is scaled by a threshold scaling factor to determine a threshold voltage; and the threshold voltage is used in determining if a fault has occurred.

4. The method of any preceding claim, wherein the capacitor voltage is scaled by a capacitor scaling factor to define a scaled capacitor voltage; and the scaled capacitor voltage is used in determining if a fault has occurred.

5. The method of any preceding claim, the method further comprising:

measuring a voltage difference between the capacitor voltage or the scaled capacitor voltage and the subsequent stage first rail voltage to define a measured voltage; and using the measured voltage in determining if a fault has occurred.

6. The method of claim 5, wherein the measured voltage is compared against the threshold voltage to determine if a fault has occurred

7. The method of claim 6, wherein if the measured voltage is less than the threshold voltage then a fault has occurred.

8. A circuit for detecting an insulation fault in an unearthed electrical system, the system comprising a first rail and a second rail, each rail having an insulation resistance; the circuit comprising:

a timing component configured to output a timing signal which configures the circuit into an initial configuration or a subsequent configuration; wherein the initial configuration comprises:

a first resistive component connected between the first rail and a relative ground, wherein the first rail has an initial first rail voltage in the initial configuration; and a capacitor connected to the first rail, wherein the capacitor has a capacitor voltage resulting from charging by the first rail in the initial configuration;

wherein the subsequent configuration comprises:

a second resistive component connected between the second rail and a relative ground; wherein the first rail has a subsequent first rail voltage in the subsequent configuration and the second rail has a subsequent second rail voltage;

the circuit further comprising circuitry configured to use the capacitor voltage and the subsequent first rail voltage to determine if a fault has occurred.

9. The circuit of claim 8, wherein the circuit further comprises:

> a first operational amplifier configured to output a difference between the subsequent first rail voltage and the subsequent second rail voltage as a differential voltage;
> wherein the differential voltage is used in determining if a fault has occurred.

10. The circuit of claim 9, wherein the differential voltage is scaled by a threshold scaling component to determine a threshold voltage; and
the threshold voltage is used in determining if a fault has occurred.

11. The circuit of claim 8, 9 or 10, further comprising a scaling component configured to scale the capacitor voltage by a capacitor scaling factor to determine a scaled capacitor voltage; and
wherein the scaled capacitor voltage is used in determining if a fault has occurred.

12. The circuit of any of claims 8-11, wherein the circuit further comprises:

> a second operational amplifier configured to output a voltage difference between the capacitor voltage or the scaled capacitor voltage and the subsequent first rail voltage, the second operational amplifier output being defined as a measured voltage; and
> using the measured voltage in determining if a fault has occurred.

13. The circuit of claim 12 when dependent on claim 10, wherein the circuit further comprises:

> a comparator configured to compare the measured voltage against the threshold voltage to determine if a fault has occurred; and
> wherein if the measured voltage is less than the threshold voltage then the comparator outputs a first signal which corresponds to a fault having occurred.

14. An insulation monitoring device for an aircraft electrical system comprising the circuit of claims 9 to 13.

15. An aircraft electrical system comprising the circuit of claims 9 to 13 or the insulation monitoring device of claim 14; and
a first rail and a second rail, each rail having an insulation resistance.

Figure 1

Figure 2

Figure 3

Determine differential voltage
421

Scale differential voltage to define threshold voltage
422

Scale capacitor voltage to define scaled capacitor voltage
423

Determine measured voltage
424

Compared measured voltage against threshold voltage
425

If measured voltage is less then threshold voltage then fault has occurred
426

Connect first rail to ground through load resistor
310

Charge capacitor using first rail
320

Connect second rail to ground through load resistor
410

Use capacitor voltage and subsequent stage first rail voltage to determine if fault has occurred
420

Initial stage
300

Subsequent stage
400

Figure 4

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/413034 A1 (LODER DAVID [US] ET AL) 29 December 2022 (2022-12-29) * paragraph [0013] – paragraph [0042]; figure 1 * | 1-15 | INV. G01R27/18 G01R31/52 |
| A | US 9 046 559 B2 (LINDSAY RYAN [US]; WHITE ROGER [US] ET AL.) 2 June 2015 (2015-06-02) * column 5, line 13 – column 5, paragraph 47; figure 2 * | 1-15 | |
| A | US 5 818 236 A (SONE TOSHIHIRO [JP] ET AL) 6 October 1998 (1998-10-06) * column 3, line 51 – column 4, line 20; figure 1 * | 1-15 | |

TECHNICAL FIELDS
SEARCHED      (IPC)

G01R

The present search report has been drawn up for all claims

| Place of search | Date of completion of the search | Examiner |
|---|---|---|
| Munich | 10 November 2023 | O'Callaghan, D |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 17 9291

This annex lists the patent family members relating to the patent documents cited in the above-mentioned European search report.
The members are as contained in the European Patent Office EDP file on
The European Patent Office is in no way liable for these particulars which are merely given for the purpose of information.

10-11-2023

| Patent document cited in search report | | Publication date | Patent family member(s) | | Publication date |
|---|---|---|---|---|---|
| US 2022413034 | A1 | 29-12-2022 | NONE | | |
| US 9046559 | B2 | 02-06-2015 | NONE | | |
| US 5818236 | A | 06-10-1998 | JP | 3224977 B2 | 05-11-2001 |
| | | | JP | H08226950 A | 03-09-1996 |
| | | | US | 5818236 A | 06-10-1998 |

For more details about this annex : see Official Journal of the European Patent Office, No. 12/82